# EUROPEAN PATENT APPLICATION

(11) **EP 4 821 637 A2**
(43) Date of publication of application: **14.10.2026**
(21) Application number: 26171437.2
(22) Date of filing: 09.04.2026
(51) Int. Cl.: B25B 9/02, B25B 5/14, B25B 27/06

(54) **CONSUMABLE BUSHING INSTALLATION ALIGNMENT TOOL**

(30) Priority: 11.04.2025 US 202519176324
(71) Applicant: RTX Corporation, Farmington, CT 06032 (US)
(72) Inventor: Chandler, Eric K., Haddam Neck, CT 06424 (US)
(74) Representative: Schmitt-Nilson Schraud Waibel Wohlfrom Patentanwälte Partnerschaft mbB

(57) **Abstract**

An alignment tool including a base ring having a base ring inside diameter bounded by a base ring inner surface, the base ring comprising a top surface opposite a bottom surface; a stabilizer ring having a stabilizer ring inside diameter bounded by a stabilizer ring inner surface, the stabilizer ring comprising a stabilizer ring upper surface opposite a stabilizer ring lower surface; a biasing member in operative communication between the base ring top surface and the stabilizer ring lower surface; a gap formed between the base ring and the stabilizer ring; and at least one pull tab formed from the base ring.

## Description

The present disclosure is directed to the improved bushing alignment tool.

While installing press fit or tight slip fit bushings or bearings, the bushing or bearing must remain parallel to the surface of the receiver to avoid becoming misaligned or cocked. Misalignment can result in marring the interface surface and creates areas of potential high stress or weakness.

In accordance with the present disclosure, there is provided an alignment tool comprising a base ring having a base ring inside diameter bounded by a base ring inner surface, the base ring comprising a top surface opposite a bottom surface; a stabilizer ring having a stabilizer ring inside diameter bounded by a stabilizer ring inner surface, the stabilizer ring comprising a stabilizer ring upper surface opposite a stabilizer ring lower surface; a biasing member in operative communication between the base ring top surface and the stabilizer ring lower surface; a gap formed between the base ring and the stabilizer ring; and at least one pull tab formed from the base ring.

Particular embodiments further may include at least one, or a plurality of, the following optional features, alone or in combination with each other:

A further embodiment of any of the foregoing embodiments may additionally and/or alternatively include multiple biasing members are arrayed as a helix about a circumference of the alignment tool.

A further embodiment of any of the foregoing embodiments may additionally and/or alternatively include the biasing member is canted between the base ring and the stabilizer ring, wherein a tilt of the biasing member includes an angle relative to the base ring top surface or the stabilizer ring lower surface.

A further embodiment of any of the foregoing embodiments may additionally and/or alternatively include the biasing member comprises a biasing force which is configured to provide structural support to the biasing member between the base ring and the stabilizer ring to maintain an initial spacing, wherein the initial spacing comprises a distance between the base ring and the stabilizer ring prior to an installation of the alignment tool.

A further embodiment of any of the foregoing embodiments may additionally and/or alternatively include the biasing member is configured to flex into a seated spacing position, wherein the seated spacing position represents a position of a bushing/bearing relative to a bushing/bearing receiver during an installation of the bushing/bearing including a predetermined alignment between the bushing/bearing relative to the bushing/bearing receiver.

A further embodiment of any of the foregoing embodiments may additionally and/or alternatively include the alignment tool further comprising an indicator feature in operative communication with the alignment tool; wherein the indicator feature is configured to visually indicate attainment of a seated spacing position.

A further embodiment of any of the foregoing embodiments may additionally and/or alternatively include the alignment tool comprises a tear away zone, wherein the tear away zone comprises structural features configured to create a yield strength capable of failure responsive to an application of a pulling force to the pull tab.

In accordance with the present disclosure, there is provided an alignment tool for installation of a bushing/bearing comprising a base ring having a base ring inside diameter bounded by a base ring inner surface, the base ring comprising a top surface opposite a bottom surface; a stabilizer ring having a stabilizer ring inside diameter bounded by a stabilizer ring inner surface, the stabilizer ring comprising a stabilizer ring upper surface opposite a stabilizer ring lower surface; multiple biasing members are arrayed as a helix about a circumference of the alignment tool in operative communication between the base ring top surface and the stabilizer ring lower surface, wherein the biasing member is canted between the base ring and the stabilizer ring; and at least one pull tab formed from the base ring.

Particular embodiments further may include at least one, or a plurality of, the following optional features, alone or in combination with each other:

A further embodiment of any of the foregoing embodiments may additionally and/or alternatively include the alignment tool comprises an initial spacing, wherein the initial spacing comprises a distance between the base ring and the stabilizer ring.

A further embodiment of any of the foregoing embodiments may additionally and/or alternatively include the biasing members are configured to flex into a seated spacing position, wherein the seated spacing position represents a position of a bushing/bearing relative to a bushing/bearing receiver during an installation of the bushing/bearing including a predetermined alignment between the bushing/bearing relative to the bushing/bearing receiver.

A further embodiment of any of the foregoing embodiments may additionally and/or alternatively include the alignment tool further comprising an indicator feature in operative communication with the alignment tool; wherein the indicator feature is configured to visually indicate attainment of a seated spacing position.

A further embodiment of any of the foregoing embodiments may additionally and/or alternatively include the alignment tool comprises at least one tear away zone, wherein the at least one tear away zone comprises structural features configured to create a yield strength capable of failure responsive to an application of a pulling force to the pull tab.

A further embodiment of any of the foregoing embodiments may additionally and/or alternatively include a tilt of the multiple biasing members includes an angle relative to the base ring top surface and the stabilizer ring lower surface.

In accordance with the present disclosure, there is provided a process of forming an alignment tool comprising forming a base ring comprising a base ring inside diameter bounded by a base ring inner surface, the base ring comprising a top surface opposite a bottom surface; forming a stabilizer ring comprising a stabilizer ring inside diameter bounded by a stabilizer ring inner surface, the stabilizer ring comprising a stabilizer ring upper surface opposite a stabilizer ring lower surface; forming multiple biasing members arrayed as a helix about a circumference of the alignment tool in operative communication between the base ring top surface and the stabilizer ring lower surface, wherein the biasing member is canted between the base ring and the stabilizer ring; and forming at least one pull tab formed from the base ring.

Particular embodiments further may include at least one, or a plurality of, the following optional features, alone or in combination with each other:

A further embodiment of any of the foregoing embodiments may additionally and/or alternatively include the process further comprising forming the alignment tool with an initial spacing, wherein the initial spacing comprises a distance between the base ring and the stabilizer ring.

A further embodiment of any of the foregoing embodiments may additionally and/or alternatively include the process further comprising configuring the biasing members to flex into a seated spacing position, wherein the seated spacing position represents a position of a bushing/bearing relative to a bushing/bearing receiver during an installation of the bushing/bearing including a predetermined alignment between the bushing/bearing relative to the bushing/bearing receiver.

A further embodiment of any of the foregoing embodiments may additionally and/or alternatively include the process further comprising forming an indicator feature in operative communication with the alignment tool; and configuring the indicator feature to visually indicate attainment of a seated spacing position.

A further embodiment of any of the foregoing embodiments may additionally and/or alternatively include the process further comprising forming at least one tear away zone in at least one of the base ring, the stabilizer ring and at least one of the biasing members; and configuring the at least one tear away zone comprising structural features configured to create a yield strength capable of failure responsive to an application of a pulling force to the at least one pull tab.

A further embodiment of any of the foregoing embodiments may additionally and/or alternatively include the process further comprising forming a tilt in the multiple biasing members including an angle relative to the base ring top surface and the stabilizer ring lower surface.

A further embodiment of any of the foregoing embodiments may additionally and/or alternatively include the process further comprising configuring the alignment tool to tear apart at the base ring, the stabilizer ring and at least one of the multiple biasing members responsive to a pulling force being applied to the pull tabs.

Other details of the alignment tool are set forth in the following detailed description and the accompanying drawings wherein like reference numerals depict like elements.

The above and further advantages of this disclosure may be better understood by referring to the following description in conjunction with the accompanying drawings, in which like reference numerals indicate like elements and features in the various figures. Letters may be appended to reference numbers to distinguish from reference numbers for similar features and to indicate a correspondence to other features in the drawings. For clarity, not every element may be labeled in every figure. The drawings are not necessarily to scale, emphasis instead being placed upon illustrating the principles of the disclosure.
Fig. 1 is a schematic representation of an exemplary alignment tool.
Fig. 2 is a schematic representation of an exemplary alignment tool with a bushing.
Fig. 3 is a schematic representation of an exemplary alignment tool during an installation.
Fig. 4 is a schematic representation of an exemplary alignment tool during an installation.

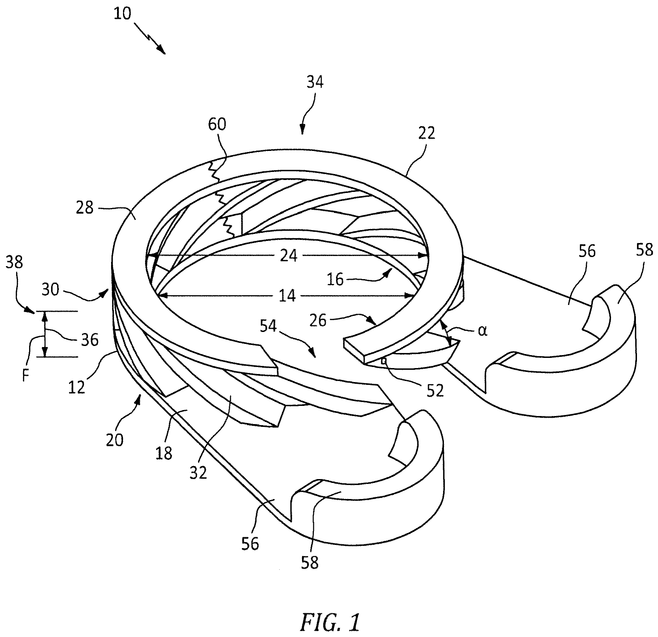

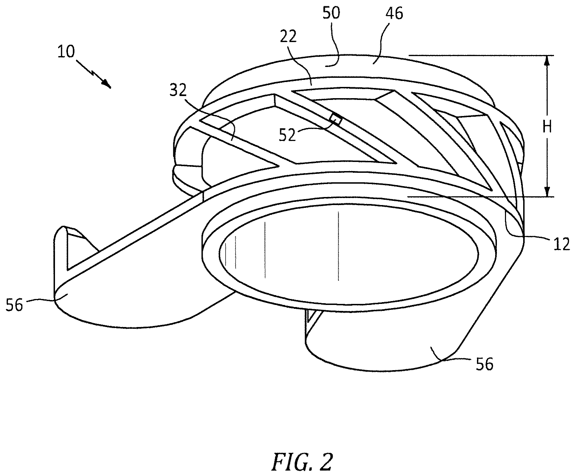

Referring now to Fig. 1 through Fig. 4 an exemplary alignment tool 10 is shown. The alignment tool 10 includes a base ring 12. The base ring 12 includes a base ring inside diameter 14 defined by a base ring inner surface 16. The base ring 12 includes a top surface 18 and a bottom surface 20 opposite the top surface 18. The base ring inside diameter 14 can correspond to an outside diameter of a bushing or bearing to be installed.

The alignment tool 10 includes a stabilizer ring 22. The stabilizer ring 22 includes a stabilizer ring inside diameter 24 defined by a stabilizer ring inner surface 26. The stabilizer ring 22 includes a stabilizer ring upper surface 28 opposite a stabilizer ring lower surface 30. The stabilizer ring inside diameter 24 can be equal to the base ring inside diameter 14.

The alignment tool 10 includes a biasing member 32 in operative communication between the base ring 12 and the stabilizer ring 22. There can be multiple biasing members 32 arrayed as a helix about a circumference 34 of the alignment tool 10. The biasing member 32 extends between the base ring top surface 18 and the stabilizer ring lower surface 30. The biasing member 32 extends along each of the base ring top surface 18 and the stabilizer ring lower surface 30 up to but not beyond the base ring inside diameter 14 and the stabilizer ring inside diameter 24.

The biasing member 32 can include a thickness dimension T. The thickness of the biasing member 32 can be from about 2 percent to about 15 percent of the base ring inside diameter 14. In an exemplary embodiment the thickness of the biasing member can be about 5 percent of the base ring inside diameter 14.

The biasing member 32 can be canted between the base ring 12 and the stabilizer ring 22. The tilt of the biasing member 32 can have an angle Alpha(α) relative to the base ring top surface 18 or the stabilizer ring lower surface 30. The tilt of the biasing member 32 can influence the spring response characteristics of the alignment tool 10. The angle Alpha(α) can be formed from between 10 degrees to about 28 degrees. The angle Alpha(α) can be formed at about 30 degrees plus or minus 5 degrees. These angles provide advantages relative to the response of the stabilizer ring 22 relative to the base ring 12 under compression.

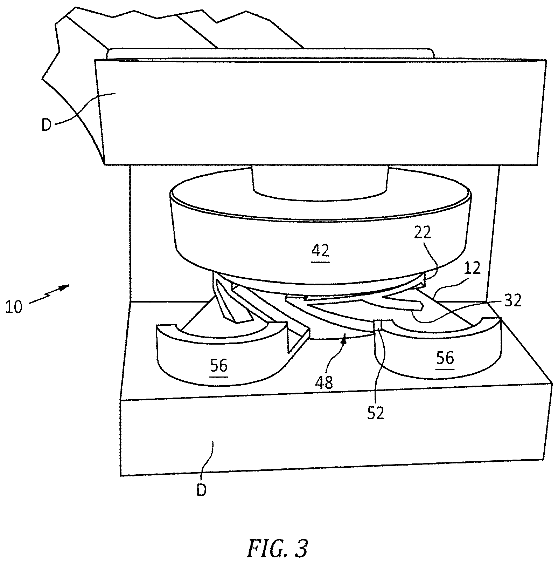

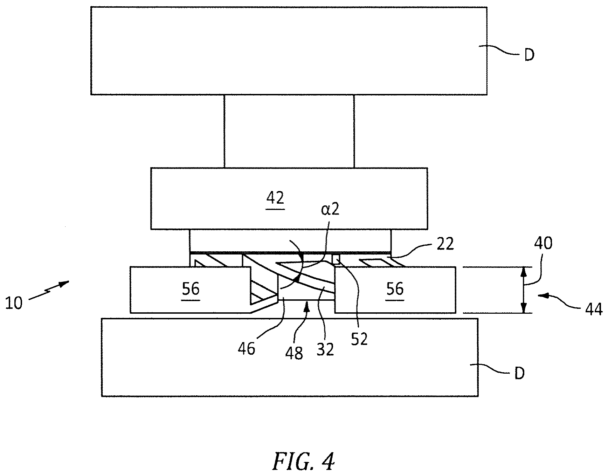

The biasing member 32 can provide a biasing force F 36. The biasing force 36 provides the structural support of the biasing member(s) 32 between the base ring 12 and the stabilizer ring 22 to maintain an initial spacing 38. The initial spacing 38 can be the distance between the base ring 12 and the stabilizer ring 22 prior to installation of the alignment tool 10. The initial spacing 38 can be varied depending upon the relative sizes of the alignment tool 10 to the device being stabilized. The biasing member 32 can deflect in reaction to a compressive force C 40. The compressive force 40 pushes the stabilizer ring 22 toward the base ring 12 decreasing the initial spacing 38 dimension. The compressive force 40 can be applied by a bushing installation tool 42, for example seen in Fig. 3, Fig. 4.

The compressive force 40 presses the stabilizer ring 22 toward the base ring 12 closing or shortening the initial spacing 38 to a seated spacing position 44 as seen in Fig 4. The seated spacing position 44 represents a position of a bushing/bearing 46 relative to a bushing/bearing receiver 48 during installation of the bushing/bearing 46 when a proper alignment has been achieved. The term bushing/bearing 46 is shorthand for a bushing or a bearing style device that is to be inserted into the orifice or cavity of a device D that is intended to mount and support the bushing or bearing after installation. The bushing/bearing 46 is a generally cylinder shaped device that fits snugly into the base ring inside diameter 14 and the stabilizer ring inside diameter 24.

The bushing/bearing receiver 48 is the device that receives the bushing/bearing 46 for mounting. The bushing/bearing receiver 48 can be a cylinder shaped bore that is sized to snugly receive the insertion of the bushing/bearing 46. The bushing/bearing 46 is inserted into the bushing/bearing receiver 48 with the aid of the alignment tool 10. The alignment tool 10 provides the bushing/bearing 46 support and proper alignment such that upon initiation of the bushing installation tool 42 the bushing/bearing 46 can properly slide into the bushing/bearing receiver 48 without galling or marring or unwanted contact between the bushing/bearing 46 and the bushing/bearing receiver 48. The bushing installation tool 42 is configured to press the bushing/bearing 46 into the bushing/bearing receiver 48.

The alignment tool 10 can be sized to snugly fit over an outside diameter/surface 50 of the bushing/bearing 46. The alignment tool 10 can be interference fit with the outside surface 50 of the bushing/bearing 46. The bushing /bearing 46 can have a predetermined height H. The alignment tool 10 can extend a portion of the predetermined height H and not exceed the height H.

The alignment tool 10 can include an indicator feature 52 attached or formed integral with the alignment tool 10. The indicator feature 52 can be configured to visually indicate when the seated spacing position 44 has been attained. The indicator feature 52 can be a raised portion of a predetermined dimension, that contacts a portion of the alignment tool 10 responsive to the seated spacing position 44 being attained. For example, the indicator feature 52 can be a post extending from the base ring 12. Upon application of the compressive force 40 as the bushing/bearing 46 is pressed into the bushing/bearing receiver 48 the stabilizer ring 22 can be pressed closer to the base ring 12. Upon attainment of the seated spacing position 44, the indicator feature 52 can contact the stabilizer ring 22, at the stabilizer ring lower surface 30. The indicator feature 52 can provide a visual indication that the alignment tool 10 can be removed at that point in the process of inserting the bushing/bearing 46.

Another example of the indicator feature 52 can be a visual indication within the alignment tool 10 that reveals a certain amount of deformation of the material, such as a discoloration or change in color tone. For example, if the color of the alignment tool 10 is grey, then the indicator feature 52 can be a lighter shade of grey or almost white color indicating that a portion of the alignment tool 10 has been deformed to the point of attaining the seated spacing position 44. An example could include the biasing member 32 deflects from an initial angle alpha 1 to a final angle alpha 2 upon being deflected down to the position in which the seated spacing position 44 has been attained. The indicator feature 52 can visually indicate that the final angle alpha 2 has been reached. The indicator feature 52 can que the operator performing the installation of the bushing/bearing 46 that the seated spacing position 44 has been attained and the alignment tool 10 can be removed.

The alignment tool 10 can include a gap 54 formed between each of the base ring 12 and the stabilizer ring 22. The gap 54 allows for the free movement of the base ring 12 and stabilizer ring 22 to enhance installation and removal of the alignment tool 10 from the position surrounding the bushing/bearing 46 upon attainment of the seated spacing position 44. The gap 54 is a break in the circumference of the alignment tool 10.

The alignment tool 10 includes a pull tab 56. In the embodiment shown, there are two pull tabs 56. The pull tap 56 can be formed from the base ring 12. The pull tab 56 can be an extension of the base ring 12. The pull tab 56 can include a wall portion 58. The wall portion 58 can extend distally from the base ring top surface 18. The wall portion 58 can be formed as a semi-circular shaped wall 60 that can be grasped by fingers of an operator or a tool configured for applying a pulling force to remove the alignment tool 10 from a position of encirclement around the bushing/bearing 46. The pull tabs 56 can be rigid and include enough yield strength to maintain structural integrity while being pulled.

The alignment tool 10 can be torn apart at both the base ring 12 and the stabilizer ring 22 and biasing member 32 with sufficient pulling force being applied to the pull tabs 56. The alignment tool 10 can be split apart, for removal without fracturing into multiple pieces, so that all of the alignment tool 10 can be removed away from the bushing/bearing 46 avoiding any foreign object fouling during installation of the bushing/bearing 46. The alignment tool 10 can be constructed with the materials and dimensions that allow for the alignment tool 10 to perform the function of aligning the bushing/bearing 46 in a stable fashion while also allowing for the alignment tool 10 to be torn apart to be removed from the bushing/bearing 46 after the seated spacing position 44 has been attained.

The alignment tool 10 can include a tear away zone 60. The tear away zone 60 can include structural features that weaken or otherwise create a yield strength capable of failure responsive to the application of the pulling force to the pull tabs 56. Those features can include but are not limited to cuts, bores, thinned wall thickness, pores, and the like. The tear away zone 60 can be located opposite the gap 54 in an exemplary embodiment. In an alternative embodiment, instead of the gap 54, the alignment tool 10 can include a first tear away zone 60 proximate the pull tab 56 and another tear away zone 60 opposite the first tear away zone 60. The tear away zone 60 can ensure proper removal of the alignment tool 10 by allowing for the alignment tool 10 to split apart and be pulled away from contact with the bushing/bearing 46 outside diameter 50. Once the alignment tool 10 has been removed, the bushing/bearing 46 can continue to be pressed into place inside the bushing/bearing receiver 48 without interference from the alignment tool 10.

The alignment tool 10 can be manufactured from printable materials, such as printable plastic materials, with solid fill. The alignment tool 10 can be a three dimensional printed tool that surrounds the bushing/bearing 46 and keeps the bushing/bearing 46 aligned as the bushing/bearing 46 is drawn or pressed into the receiving hole 48. The design of the alignment tool 10 allows for the alignment tool 10 to crush and then be broken away once the bushing/bearing 46 is started in the receiving hole 48 and aligned. The alignment tool 10 has a spring like quality and has pull tabs 56 to aid in removal.

A technical advantage of the disclosed alignment tool includes a device that aligns a bushing for installation into a mounting receiver with tear away features to enable full removal of the alignment tool.

Another technical advantage of the disclosed alignment tool includes an indicator feature attached or formed integral with the alignment tool in which the indicator feature is configured to visually indicate when the seated spacing position has been attained.

Another technical advantage of the disclosed alignment tool includes structural features that weaken or otherwise create a yield strength capable of failure responsive to the application of the pulling force to the pull tabs of the alignment tool.

Another technical advantage of the disclosed alignment tool includes a biasing member in operative communication between the base ring and the stabilizer ring, multiple biasing members can be arrayed as a helix about a circumference of the alignment tool.

Another technical advantage of the disclosed alignment tool includes a structure that can easily be attached to and removed from the bushing/bearing to prevent the bushing/bearing from being tilted or cocked over during installation of the bushing/bearing.

There has been provided an alignment tool. While the alignment tool has been described in the context of specific embodiments thereof, other unforeseen alternatives, modifications, and variations may become apparent to those skilled in the art having read the foregoing description. Accordingly, it is intended to embrace those alternatives, modifications, and variations which fall within the broad scope of the appended claims.

## Claims

1. An alignment tool comprising:
a base ring having a base ring inside diameter bounded by a base ring inner surface, the base ring comprising a top surface opposite a bottom surface;
a stabilizer ring having a stabilizer ring inside diameter bounded by a stabilizer ring inner surface, the stabilizer ring comprising a stabilizer ring upper surface opposite a stabilizer ring lower surface;
a biasing member in operative communication between the base ring top surface and the stabilizer ring lower surface;
a gap formed between the base ring and the stabilizer ring; and
at least one pull tab formed from the base ring.

2. The alignment tool according to claim 1, wherein multiple biasing members are arrayed as a helix about a circumference of the alignment tool.

3. The alignment tool according to claim 1 or 2, wherein the biasing member is canted between the base ring and the stabilizer ring, wherein a tilt of the biasing member includes an angle relative to the base ring top surface or the stabilizer ring lower surface.

4. The alignment tool according to any of claims 1 to 3, wherein the biasing member comprises a biasing force which is configured to provide structural support to the biasing member between the base ring and the stabilizer ring to maintain an initial spacing, wherein the initial spacing comprises a distance between the base ring and the stabilizer ring prior to an installation of the alignment tool.

5. The alignment tool according to any of claims 1 to 4, wherein the biasing member is configured to flex into a seated spacing position, wherein the seated spacing position represents a position of a bushing/bearing relative to a bushing/bearing receiver during an installation of the bushing/bearing including a predetermined alignment between the bushing/bearing relative to the bushing/bearing receiver.

6. An alignment tool for installation of a bushing/bearing comprising:
a base ring having a base ring inside diameter bounded by a base ring inner surface, the base ring comprising a top surface opposite a bottom surface;
a stabilizer ring having a stabilizer ring inside diameter bounded by a stabilizer ring inner surface, the stabilizer ring comprising a stabilizer ring upper surface opposite a stabilizer ring lower surface;
multiple biasing members are arrayed as a helix about a circumference of the alignment tool in operative communication between the base ring top surface and the stabilizer ring lower surface, wherein the biasing member is canted between the base ring and the stabilizer ring; and
at least one pull tab formed from the base ring.

7. The alignment tool according to claim 6, wherein the alignment tool comprises an initial spacing, wherein the initial spacing comprises a distance between the base ring and the stabilizer ring; and/or
wherein the biasing members are configured to flex into a seated spacing position, wherein the seated spacing position represents a position of a bushing/bearing relative to a bushing/bearing receiver during an installation of the bushing/bearing including a predetermined alignment between the bushing/bearing relative to the bushing/bearing receiver.

8. The alignment tool according to any of claims 1 to 7, further comprising:
an indicator feature in operative communication with the alignment tool; wherein the indicator feature is configured to visually indicate attainment of a seated spacing position.

9. The alignment tool according to any of claims 1 to 8, wherein the alignment tool comprises at least one tear away zone, wherein the at least one tear away zone comprises structural features configured to create a yield strength capable of failure responsive to an application of a pulling force to the pull tab.

10. The alignment tool according to any of claims 6 to 8, wherein a tilt of the multiple biasing members includes an angle relative to the base ring top surface and the stabilizer ring lower surface.

11. A process of forming an alignment tool comprising:
forming a base ring comprising a base ring inside diameter bounded by a base ring inner surface, the base ring comprising a top surface opposite a bottom surface;
forming a stabilizer ring comprising a stabilizer ring inside diameter bounded by a stabilizer ring inner surface, the stabilizer ring comprising a stabilizer ring upper surface opposite a stabilizer ring lower surface;
forming multiple biasing members arrayed as a helix about a circumference of the alignment tool in operative communication between the base ring top surface and the stabilizer ring lower surface, wherein the biasing member is canted between the base ring and the stabilizer ring; and
forming at least one pull tab formed from the base ring.

12. The process according to claim 11, further comprising:
forming the alignment tool with an initial spacing, wherein the initial spacing comprises a distance between the base ring and the stabilizer ring.

13. The process according to claim 11 or 12, further comprising:
configuring the biasing members to flex into a seated spacing position, wherein the seated spacing position represents a position of a bushing/bearing relative to a bushing/bearing receiver during an installation of the bushing/bearing including a predetermined alignment between the bushing/bearing relative to the bushing/bearing receiver; and/or
further comprising:
forming an indicator feature in operative communication with the alignment tool; and
configuring the indicator feature to visually indicate attainment of a seated spacing position.

14. The process according to any of claims 11 to 13, further comprising:
forming at least one tear away zone in at least one of the base ring, the stabilizer ring and at least one of the biasing members; and
configuring the at least one tear away zone comprising structural features configured to create a yield strength capable of failure responsive to an application of a pulling force to the at least one pull tab.

15. The process according to any of claims 11 to 14, further comprising:
forming a tilt in the multiple biasing members including an angle relative to the base ring top surface and the stabilizer ring lower surface; and/or
further comprising:
configuring the alignment tool to tear apart at the base ring, the stabilizer ring and at least one of the multiple biasing members responsive to a pulling force being applied to the pull tabs.
